# EUROPEAN PATENT APPLICATION

(11) **EP 1 014 767 A1**
(43) Date of publication of application: **28.06.2000**
(21) Application number: 98310699.8
(22) Date of filing: 23.12.1998
(51) Int. Cl.: H05K 3/30, H05K 3/34

(54) **Thermal stress relief for surface mount components using via filling**

(71) Applicant: LUCENT TECHNOLOGIES INC., Murray Hill, New Jersey 07974-0636 (US)
(72) Inventor: Clancy, Jeff Anthony, Dublin 9 (IE); Cooper, Stephen, Swindon SN5 5DQ (GB); Falaki, Hamid Reza, Wiltshire SN5 5AA (GB); Feichtenbeiner, Michael, 90587 Veitsbronn (DE); Jones, Peter Gavin, Gloucestershire GL3 1LT (GB); Sparkes, Stephen David, Farnborough, Hants (GB); Vellani, Simeon, Wiltshire SN2 3QY (GB)
(74) Representative: Williams, David John

(57) **Abstract**

There is disclosed a circuit board (6) for mounting a surface mount package (2). The circuit board (6) has a mounting space (40) for receiving the surface mount package (2). A plurality of openings (34) is provided in the space extending from one side of the board to the other. The openings (34) are for receiving solder such that the solder extends (36,38) from the openings (34) above the surface of the circuit board, thereby to support the surface mount package (2). A method of making such a board (6), and a method of mounting a surface mount package (2) on such a board (6) are also disclosed.

## Description

### Field of the Invention

The present invention relates to surface mount technology, and in particular to a technique for relieving the thermal stress between a surface mount package and the circuit board on which it is mounted.

### Background to the Invention

Surface mount technology provides advantageous size efficiency in allowing increased component packing density. In the mobile (or cordless) telecommunications industry surface mount technology advantageously enables the size of both mobile hand-sets and base stations to be minimised.

In using surface mount technology, a thermal mis-match exists between the surface mount packages (or devices) and the boards on which they are mounted. In some instances surface mount packages are provided with ceramic bases which are to be soldered to copper conductive pads on a printed circuit board or printed wave board.

The thermal mis-match problem arises because the ceramic surface mount package and the circuit board each have a different CTE (coefficient of thermal expansion). The printed circuit board is typically made of a material such as FR4, which expands at a much greater rate than the ceramic material of the surface mount package under thermal stress.

This thermal mis-match is a problem during manufacture (when the solder is heated to make the connection between the ceramic package and the copper board). In communication applications, it is also a problem in use. Base stations for mobile telecommunications applications are manufactured to withstand temperature variations from -10°C (and down to -45°C in storage) up to 20°C (typical normal temperature of operation) and 85°C. This severe range of temperatures causes contraction and expansion of the materials in use. Thus, even if the assembled equipment passes a production test, it is still possible that the equipment will fail in the field due to thermal expansion effects introduced in the field.

This problem introduced by the thermal mis-match is generally known, and it is also known to attempt to overcome this problem by increasing the height of the solder column between the surface mount package terminal and the circuit board pad. Increasing the height of the solder column spreads the total stress over a greater mass and decreases the stress per unit mass, such that the column bends under stress rather than shearing.

However, the implementation of such a mounting scheme is not straightforward. It is difficult to increase the solder column height without introducing unnecessary complications in the assembly process.

It is an object of the present invention to provide a simple solution to the problem of thermal stresses in solder joints between surface mount packages and circuit boards.

### Summary of the Invention

According to the invention there is provided a circuit board for mounting a surface mount package, the circuit board having a mounting space for receiving the surface mount package, a plurality of openings being provided in the space extending from one side of the board to the other, the openings being for receiving solder such that the solder extends from the openings above the surface of the circuit board thereby to support the surface mount package.

The circuit board may include a conductive pattern, matching the footprint of the surface mount package, in the mounting space, the openings being provided in areas of the mounting space other than the conductive pattern.

The circuit board may have a plurality of mounting spaces with respective pluralities of openings.

The invention also provides a method of making a circuit board for mounting a surface mount package, comprising: defining a mounting space in the circuit board for receiving a surface mount package; providing a pattern of openings in the mounting space area of the circuit board extending from one side thereof to another side thereof; and providing solder in each of the openings such that the solder extends from the openings above the surface of the circuit board thereby to support the surface mount package.

The method may further comprise the step of forming a solder mask over the solder extending from each opening.

The invention still further provides a method of mounting a surface mount package on a circuit board having a mounting space for receiving a surface mount package, the mounting space having a plurality of openings extending from one side of the circuit board to another side thereof, and each opening having a solder fill that extends above the surface of the circuit board, the method comprising: placing the surface mount package on the circuit board such that the surface mount package is supported by the plurality of solder fills with the footprint of the surface mount package suspended above a conductive pattern in the mounting space, the conductive pattern corresponding to the footprint of the surface mount device; and performing a solder re-flow such that the solder connects the footprint of the surface mount package to the conductive pattern.

The invention also provides a circuit board for mounting a surface mount package, the circuit board having a mounting space for receiving the surface mount package, a plurality of openings being provided in the space extending from one side of the board to the other, the openings being filled with solder such that the solder extends from the openings above the surface of the circuit board thereby to support the surface mount package.

### Brief Description of the Drawings

Figure 1 shows a standard surface mount assembly;
Figures 2 illustrates an aspect of the present invention; and
Figure 3 show a surface mount assembly according to the present invention.

### Description of Preferred Embodiment

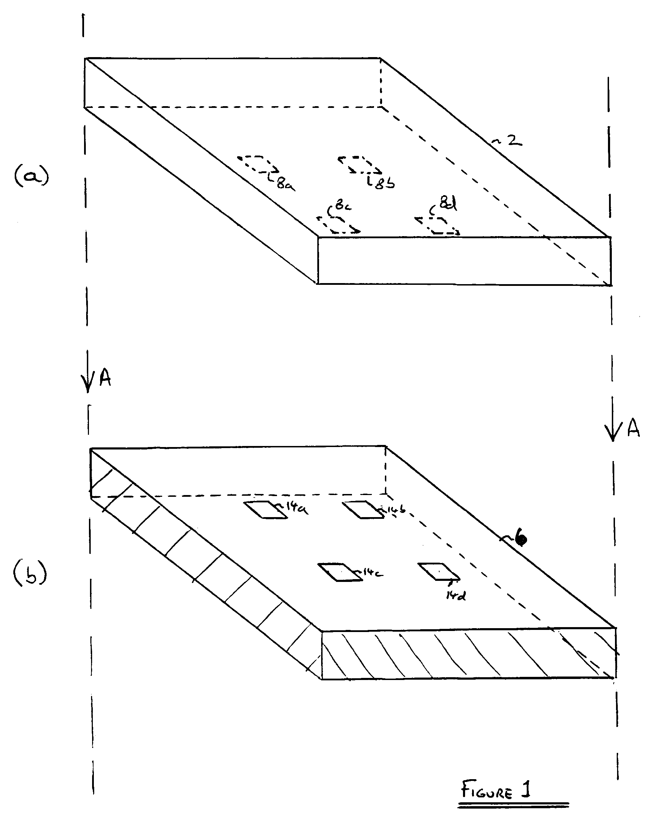

Referring to Figure 1(a) there is shown an elevated view from above of a ceramic surface mount package or device 2. The surface mount package has on the underside thereof, shown in Figure 1(a) in dashed lines since the view is from above, four contact points 8a, 8b, 8c, and 8d. The four contact points are conductive contact points on the ceramic underside of the surface mount package 2, which are intended to make electrical contact with a printed circuit board or printed wiring board onto which the surface mount package 2 is to be mounted. The four contact points 8a, 8b, 8c, and 8d create what is known as the 'footprint' of the surface mount package. The footprint is the shape of the electrical contacts of the surface mount package which stand out from the ceramic material on the remainder of the surface mount package.

Figure 1(b) shows a portion of a circuit board 6, which may be a printed circuit board or printed wiring board, onto which the surface mount package 2 of Figure 1(a) is conventionally mounted. The circuit board 6 has four conductive pads 14a, 14b, 14c, and 14d thereon. The four conductive pads will typically be connected to conductive tracks on the circuit board, which will connect the surface mount package to other circuit or system elements.

It will be apparent that the configuration pattern, or layout, of the four conductive pads 14a to 14d matches the footprint of the surface mount package 2. That is, when the surface mount package 2 of Figure 1(a) is lowered, the contact points 8a to 8d will contact respective ones of the conductive pads 14a to 14b. Thus, ordinarily, if there were no concern over thermal mis-match between materials, the surface mount package would be mounted directly onto the circuit board 6 and the contact points 8a to 8d make direct contact to the conductive pads 14a to 14b respectively. Thereafter a solder re-flow operation ensures the necessary electrical/mechanical fixing between the contact points and the conductive pads.

As discussed hereinabove, however, such an assembly will not provide for reliable connection when a thermal mis-match exists between the materials of the surface mount package and the circuit board. Therefore, according to the present invention a means for raising the surface mount component higher than is normal in the arrangement of Figure 1 is provided, which results in the height of the solder contacts between the contact points 8 and the circuit board 6 being increased.

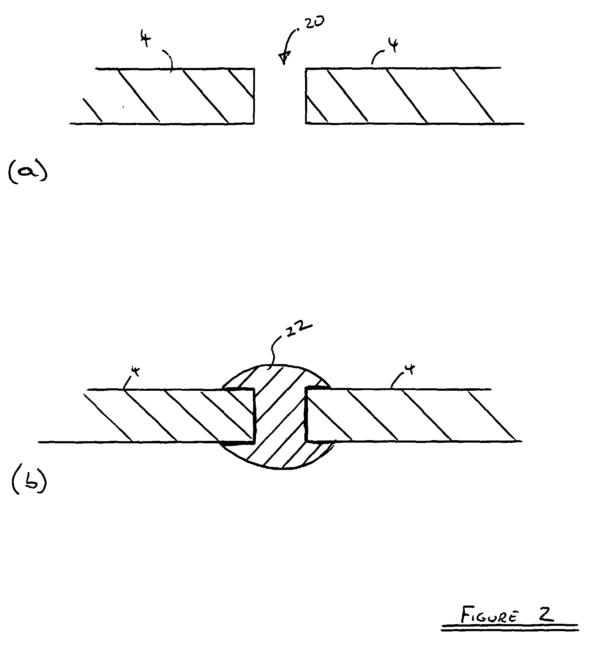

Figure 2(a) shows a portion of a standard printed circuit board 4, such as that shown in Figure 1(b). During manufacture of the circuit board, prior to assembly of components thereon, contact vias such as via 20 are drilled in certain places on the circuit board. These vias may be used for various reasons known to those skilled in the art. For example, the vias provide connection between components and tracks on opposite sides of the circuit board 4.

Referring to Figure 2(b), there is shown the circuit board 4 of Figure 2(a) including contact via 20 after performing a solder re-flow step. As can be seen form Figure 2(b), after the solder re-flow step the contact via 20 fills with a solder filling 22 which extends above and below the surface of the circuit board 4.

Thus, any component which would have been placed on the circuit board of Figure 2(a) and rested on the surface thereof, would now be suspended above the surface by an amount equal to the offset introduce by the solder filling 22 extending above the surface of the circuit board 4.

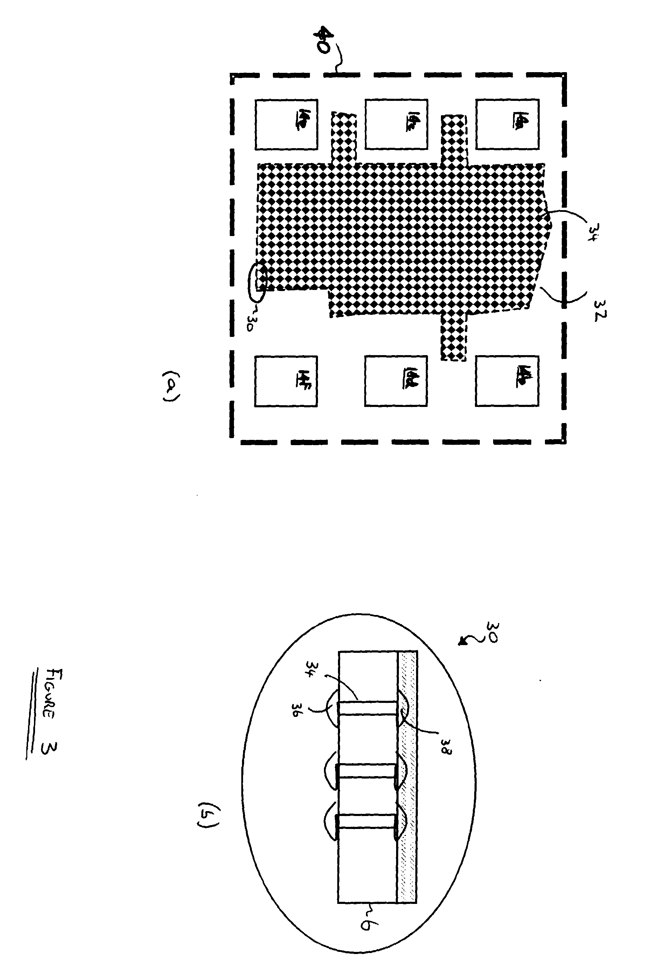

Referring to Figures 3(a) and 3(b), the circuit board for receiving surface mount components according to the present invention will now be described. Figure 3(a) shows a portion of the circuit board 6 of Figure 1(b) viewed from above. The dashed thick line designated generally by reference numeral 40 designates an area of the circuit board 6 onto which a surface mount package is to be deposited. That is, the surface mount package will be mounted onto the space designated by dashed line 40.

In the example of Figure 3(a), the circuit board is provided with a conductive pattern of six conductive pads 14a to 14f, the pattern of which matches six contact points forming a footprint of a surface mount package (not shown). In addition, in an area 32 within the space for mounting the surface mount package the circuit board is provided with a plurality of openings 34 which extend from one side of the circuit board to the other.

Figure 3(b) is an exploded cross-sectional view of three of the openings 30 in the area 32 of Figure 3(a). As can be seen in Figure 3(b), each of the openings 34 extends form a top side of the board to a bottom side of the board. In Figure 3(b), the exploded view shows the openings through the circuit board after the openings 34 have been filled with solder according to the technique described with reference to Figure 2. As can be seen, each of the openings is provided with a solder filling in the opening 34, and the solder filling extends above the circuit board 6 in a portion 38 and below the circuit board 6 in a portion 36.

In the assembly of the circuit board, the openings, or contact vias, 34 are formed during the formation of other contact vias on the board. The contact vias are each filled with solder in a solder re-flow process, such that each of the contact vias fills with a solder filling having the cross-sectional profile as shown in Figure 3(b). The solder fill process takes place as part of the Printed Wiring Board (PWB) or printed circuit board (PCB) manufacture.

The contact vias may be formed everywhere within the space 40 for receiving the surface mount package, other than the areas 14a to 14f forming the conductive pattern. Thus the contact vias may be formed in all of the area underneath where the surface mount assembly will be located, other than the locations of the conductive pads 14a to 14f.Design rules dictate locations of the contact vias, as well as the location of track layers below components. Figure 3(a) shows an irregular pattern of contact vias 34 in the mounting space 40.

Thereafter, the area where the filled contact vias are located is covered with a resin like solder mask. The pattern of the deposition of this resin is determined so as to be suitable for the component.

After the contact vias 34 are filled with solder, the surface mount package is lowered onto the board 6. Each of the six contact points of the surface mount package are positioned over one of the conductive pads 14a to 14f. The surface mount package itself rests on the tops 38 of the plurality of solder filled contact vias 34 in the area 32, such that the surface mount package is 'suspended' over the circuit board 6 at a height equivalent to the height of the solder fill extension 38 above the circuit board.

The positioning of the surface mount package above the circuit board is thus higher than is achieved in the arrangement of Figure 1, due to the formation of the solder fillings in each of the contact vias 34. Thus the contact points of the surface mount package, equivalent to the contact points 8a to 8d of the surface mount package of Figure 1, are suspended over the respective ones of the conductive pads 14a to 14f.

A solder re-flow operation is then performed, resulting in the necessary electrical contact being made between the contact points of the surface mount package and the solder fillings in the contact vias of the circuit board 6.

It can thus be seen that the height of the solder joint between the respective contact points and the respective conductive pads is increased by the provision of the solder filled contact vias. The re-flow operation to achieve the electrical and mechanical connection between the contact points and the solder fills in the contact vias does not result in a re-flow of the solder in or above the contact vias because of the resin-like solder mask formed there over. The solder used in the via is of higher melting temperature than the normal solder used for component assembly.

This increase in the height of the solder connections leads to an improved thermal reliability of the assembled circuit, since the high solder joints tend to bend or flex, rather than shear, under thermal stress.

It will be appreciated that the footprint of the surface mount package of Figures 1 and 3 is shown for purposes of example only, and may differ. Differing contact via patterns can be provided according to the footprint of the surface mount assembly to be connected to the board. It will be appreciated that none of the Figures are drawn to scale, but are drawn in the best way to exemplify the present invention.

The amount of height provided by the solder-filled contact vias will be determined by the nature of the solder used, and the depth and diameter of the contact via, both of which can be determined according to the application required.

## Claims

1. A circuit board for mounting a surface mount package, the circuit board having a mounting space for receiving the surface mount package, a plurality of openings being provided in the space extending from one side of the board to the other, the openings being for receiving solder such that the solder extends from the openings above the surface of the circuit board thereby to support the surface mount package.

2. The circuit board of claim 1 wherein the circuit board includes a conductive pattern, matching the footprint of the surface mount package, in the mounting space, the openings being provided in areas of the mounting space other than the conductive pattern.

3. The circuit board of claim 1 or claim 2 having a plurality of mounting spaces with respective pluralities of openings.

4. A method of making a circuit board for mounting a surface mount package, comprising: defining a mounting space in the circuit board for receiving a surface mount package; providing a pattern of openings in the mounting space area of the circuit board extending from one side thereof to another side thereof; and providing solder in each of the openings such that the solder extends from the openings above the surface of the circuit board thereby to support the surface mount package.

5. The method of claim 4, further comprising the step of forming a solder mask over the solder extending from each opening.

6. A method of mounting a surface mount package on a circuit board having a mounting space for receiving a surface mount package, the mounting space having a plurality of openings extending from one side of the circuit board to another side thereof, and each opening having a solder fill that extends above the surface of the circuit board, the method comprising: placing the surface mount package on the circuit board such that the surface mount package is supported by the plurality of solder fills with the footprint of the surface mount package suspended above a conductive pattern in the mounting space, the conductive pattern corresponding to the footprint of the surface mount device; and performing a solder re-flow such that the solder connects the footprint of the surface mount package to the conductive pattern.

7. A circuit board for mounting a surface mount package, the circuit board having a mounting space for receiving the surface mount package, a plurality of openings being provided in the space extending from one side of the board to the other, the openings being filled with solder such that the solder extends from the openings above the surface of the circuit board thereby to support the surface mount package.
